# DEMANDE DE BREVET EUROPEEN

(11) **EP 1 722 421 A2**
(43) Date de publication de la demande: **15.11.2006**
(21) Numéro de dépôt: 06290735.7
(22) Date de dépôt: 09.05.2006
(51) Int. Cl.: H01L 27/146

(54) **Photodiode intégrée de type à substrat flottant**

(30) Priorité: 13.05.2005 FR 0504836
(71) Demandeur: STMICROELECTRONICS SA, 92120 Montrouge (FR)
(72) Inventeur: Roy, Francois, 38130 Seyssins (FR); Tournier, Arnaud, 38000 Grenoble (FR)
(74) Mandataire: Zapalowicz, Francis

(57) **Abrégé**

Circuit intégré comprenant au moins une photodiode (PD) de type à substrat flottant, associée à un transistor de lecture (TR), ladite photodiode comportant une couche enterrée (CE) située sous le substrat flottant (SBF) et une couche supérieure (5) située sur le substrat flottant et incorporant les zones de sources (S) et de drain (D). Les zones de source et de drain sont réalisés de part et d'autre de la grille (G) du transistor de lecture (TR) et le circuit comprend une tranchée d'isolation (DTI1), située à côté de ladite zone de source, s'étendant depuis la surface supérieure de la couche supérieure (5) et au-delà de la couche enterrée (CE), de façon à isoler la zone de source (S) de ladite couche enterrée(CE).

## Description

L'invention concerne la microélectronique, notamment les circuits intégré comportant des photodiodes.

Les capteurs d'image à base de composants semi-conducteurs tirent profit du principe de la conversion des photons en paire électrons/trous dans le silicium. Plus précisément, les charges créées dans les zones photosensibles sont stockées dans la photodiode et sont ensuite lues grâce à un système électronique. Ce système électronique, qui commande la photodiode, comporte notamment un transistor de lecture réalisant la conversion des charges stockées dans la photodiode en grandeur électrique.

L'invention s'applique avantageusement mais non limitativement aux capteurs d'image CMOS, et plus particulièrement aux capteurs VMIS (« Vth Modulation Image Sensor », en langue anglaise), qui sont des capteurs d'image s'appuyant sur la modulation de la tension de seuil d'un transistor MOS. On pourra, à ce sujet, se référer à l'article de Takashi MIIDA et al., « A 1.5 Mpixel Imager with Localized Hole Modulation Method », ISSCC Dig. Tech. Pap., pp. 42-43, 7.2002.

Ce type de transistor CMOS est constitué d'une photodiode enterrée associé à un seul transistor MOS légèrement modifié, du fait que son substrat est un substrat flottant, c'est-à-dire qu'on ne peut accéder à son potentiel, par l'intermédiaire d'une électrode par exemple. Ce substrat flottant joue le rôle d'une zone de stockage de charge lors de l'intégration de celle-ci, c'est-à-dire lorsque la lumière incidente génère des paires électrons/trous dans les zones photosensibles.

Plus généralement, l'invention peut s'appliquer à toutes photodiodes de type à substrat flottant.

Classiquement, les photodiodes de type à substrat flottant réalisent l'isolation entre les différents pixels d'un capteur d'image en réalisant un transistor de lecture dans lequel la grille est de type circulaire par opposition au type rectangulaire. En effet, pour isoler complètement le substrat flottant, il est nécessaire d'entourer celui-ci d'une zone semi-conductrice de type opposé au sien tout en évitant de court-circuiter la source et le drain. Il est donc impératif de faire appel à des photodiodes ayant une grille à structure circulaire, où la couche enterrée de la photodiode est reliée au drain, mais la source est isolée de la couche enterrée par la grille du transistor de lecture qui l'entoure.

Cependant, les dispositifs possédant ce type de structure avec des transistors de lecture à grille ronde sont très encombrants.

Alors que les capteurs d'image CMOS où un seul transistor de lecture est nécessaire par pixel permettent de réduire fortement la surface du circuit intégré, l'utilisation d'un transistor à grille circulaire annule le gain réalisé en surface. Dans ce cas, un pixel associé à un circuit comportant une photodiode et un transistor de lecture à grille circulaire, représente autant d'encombrement surfacique qu'un pixel associé à un circuit classique comprenant une photodiode et quatre transistors.

L'invention vise à apporter une solution à ce problème.

Un but de l'invention est de proposer un circuit intégré pour des capteurs d'image CMOS où chaque pixel n'est associé qu'à un seul transistor de lecture, tout en ayant un encombrement minimal.

A cet effet, selon un premier aspect de l'invention, il est proposé un circuit intégré comprenant au moins une photodiode de type à substrat flottant, associée à un transistor de lecture, ladite photodiode comportant une couche enterrée située sous le substrat flottant et une couche supérieure située sur le substrat flottant et incorporant les zones de source et de drain.

Selon une caractéristique générale de ce premier aspect de l'invention, les zones de source et de drain sont réalisées de part et d'autre de la grille du transistor de lecture. En outre, le circuit comprend une tranchée d'isolation, située à côté de ladite zone de source, s'étendant depuis la surface supérieure de la couche supérieure et au-delà de la couche enterrée, de façon à isoler la zone de source de ladite couche enterrée.

En d'autres termes, l'invention permet de réaliser un circuit intégré comprenant à la fois une photodiode de type à substrat flottant et une grille rectangulaire, la source et le drain du transistor étant réalisés de part et d'autre de cette grille.

Par conséquent, l'invention permet de réaliser des capteurs d'image où chaque pixel ne peut être associé qu'à un seul transistor de lecture, et possédant un encombrement minimal.

En outre, le circuit peut comprendre avantageusement une zone de contact semi-conductrice, du même type de conductivité que la couche enterrée et électriquement isolée de la couche supérieure, s'étendant entre la surface supérieure de la couche supérieure et la couche enterrée.

Cette zone de contact semi-conductrice permet de polariser la couche enterrée de la photodiode, indépendamment de la zone de drain.

Le circuit peut comprendre une première tranchée d'isolation auxiliaire située entre la zone de drain du transistor et la photodiode, et traversant ladite couche supérieure.

Cette première tranchée d'isolation auxiliaire à pour avantage de permettre une réduction supplémentaire de la surface du circuit intégré, lors de sa réalisation sur silicium.

Dans le cas où le circuit intégré comprend une première tranchée d'isolation auxiliaire et une zone de contact semi-conductrice du même type de conductivité que la couche enterrée et électriquement isolée de la couche supérieure, il peut comprendre en outre une deuxième tranchée d'isolation auxiliaire située entre la photodiode et ladite zone de contact semi-conductrice, et traversant ladite couche supérieure.

En variante, lorsque le circuit intégré comprend une zone de contact semi-conductrice, du même type de conductivité que la couche enterrée et électriquement isolée de la couche supérieure, elle peut comprendre en outre une tranchée d'isolation auxiliaire située entre la photodiode et la zone de contact semi-conductrice, s'étendant depuis la surface supérieure de la couche supérieure et au-delà de la couche enterrée.

Selon un autre aspect de l'invention, il est proposé un circuit intégré comprenant plusieurs ensembles de photodiodes associés à des transistors de lecture, tels que définis ci-avant.

Selon un autre aspect de l'invention, il est proposé un capteur d'image comprenant un circuit intégré selon l'un quelconque des modes de réalisation définis ci-dessus, chaque ensemble de photodiode/transistor définissant un pixel du capteur.

D'autres avantages et caractéristiques de l'invention apparaîtront à l'examen de la description détaillée de plusieurs modes de réalisation et d'un exemple d'un procédé de réalisation d'un mode de réalisation, nullement limitatif, et des dessins annexés, sur lesquels :
- la figure 1 illustre de façon schématique un capteur d'image selon l'invention formé de plusieurs cellules, équipé de photodiodes selon l'invention ;
- la figure 2 représente un mode de réalisation d'un circuit intégré selon l'invention ;
- la figure 3 représente un autre mode de réalisation d'un circuit intégré selon l'invention ;
- la figure 4 représente un autre mode de réalisation d'un circuit intégré selon l'invention ;
- les figures 5 à 12 illustrent schématiquement les principales étapes d'un exemple d'un procédé de fabrication d'un circuit intégré selon l'invention ;
- la figure 13 représente un autre mode de réalisation d'un circuit intégré selon l'invention ;
- les figures 14 et 15 représentent différents exemples des réalisations sur silicium, d'un circuit intégré selon l'invention.

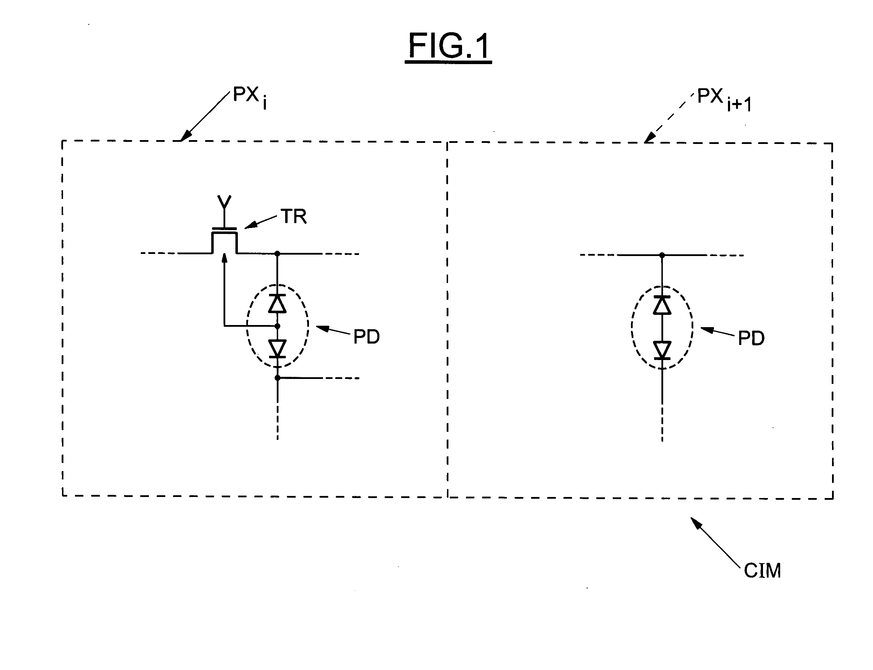

Sur la figure 1, la référence CIM désigne d'une façon générale un capteur d'image formé d'une matrice de cellules (ou pixels) PXi, comportant chacune une photodiode PD ainsi qu'un transistor de lecture TR connecté à la photodiode PD. Chaque cellule PXi peut comprendre des moyens de commande supplémentaires connectés au transistor de lecture TR, par exemple un transistor de remise à zéro, un transistor de sélection et un transistor suiveur.

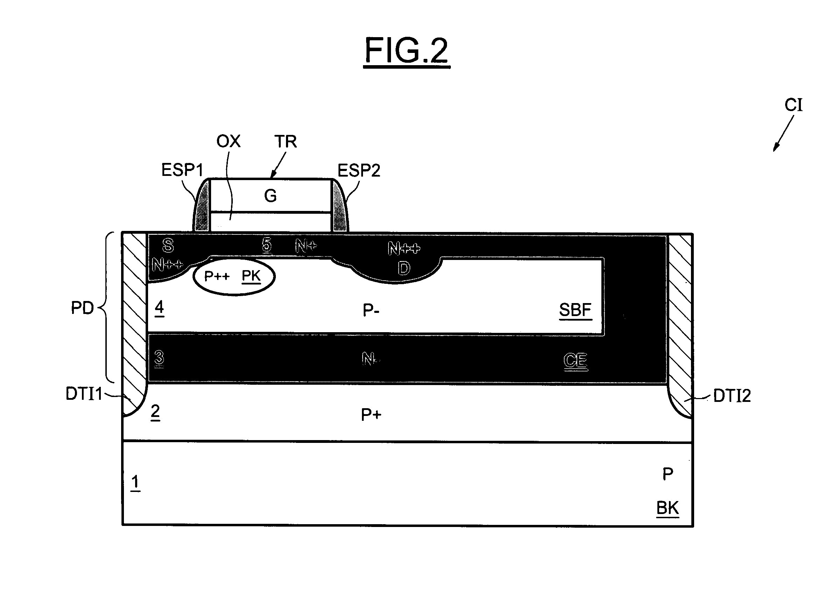

La figure 2 illustre plus en détail la structure semi-conductrice de la photodiode PD d'une cellule PXi.

La référence CI désigne un circuit intégré selon un premier mode de réalisation de l'invention, comprenant la photodiode PD au-dessus d'une couche 1 de substrat BK (« Bulk » en langue anglaise), ici dopée P et constituant le support du circuit intégré CI.

Le circuit intégré comprend également une couche 2 dopée P⁺ entre la couche 1 de support et la photodiode PD. Le rôle de cette couche 2 sera décrit plus en détail ci-après.

Le circuit CI comprend un empilement 3, 4 et 5 de couches semiconductrices situées au-dessus de la couche 2 et formant la photodiode PD.

Cet empilement comprend une couche semi-conductrice 3, ici dopée N, au-dessus de la couche 2 dopée P⁺. La couche 3 forme une couche enterrée CE, c'est-à-dire une barrière pour les charges photogénérées dans la zone photosensible de la photodiode PD.

La couche enterrée CE est surmontée d'une zone 4, dite de substrat flottant SBF, c'est-à-dire une zone fermée dont on ne peut modifier ou accéder au potentiel qu'à l'aide par exemple d'une électrode.

La zone de substrat flottant SBF comprend, dans cet exemple, une zone de stockage (« pocket », en langue anglaise) PK surdopée P⁺⁺. En effet, au lieu de stocker les charges photogénérées dans l'ensemble du substrat flottant SBF, celles-ci sont stockées dans la zone de stockage PK. Cependant, ce mode de réalisation peut également s'appliquer à des photodiodes comprenant un substrat flottant sans zone de stockage.

La photodiode PD comprend une couche supérieure 5, ici dopée N, de façon que la zone de substrat flottant soit entièrement entourée de matériau semi-conducteur d'un type de conductivité opposé, à l'exception d'un côté, tel que décrit ci-après.

Au-dessus de la couche supérieure 5, se trouve le transistor de lecture TR. Celui-ci comprend une grille G réalisée au-dessus d'une couche d'oxyde OX. En outre, on trouve ici de chaque côté de la grille deux espaceurs ESP1 et ESP2.

La source et le drain S et D dopés N⁺⁺, sont réalisés de part et d'autre de la grille rectangulaire dans la couche supérieure 5.

Etant donné que la grille du transistor de lecture TR est une grille à structure rectangulaire, et que le substrat flottant est entouré du matériau semi-conducteur de type N, on réalise une tranchée d'isolation DTI1, de façon à isoler la couche supérieure et notamment la source, de la couche enterrée CE, dopée N.

La tranchée DTI1 est du type « Deep Trench Isolation », autrement dit d'une isolation par tranchées profondes. En effet, celles-ci s'étendent depuis la surface supérieure de la couche supérieure 5 et au-delà de la couche enterrée CE, de façon à isoler la couche enterrée CE de la couche supérieure 5.

Par ailleurs, la largeur de cette tranchée DTI1 est particulièrement fine, du fait de l'existence de la couche 2 dopée P⁺, qui permet de contrôler la profondeur de la couche enterrée CE, et par conséquent d'avoir des tranchées d'isolation moins profondes.

En effet plus la tranchée est profonde, plus sa largeur en surface du circuit intégré est importante. Ainsi l'existence de la couche 2, permet de diminuer la profondeur de la tranchée DTI1 et d'optimiser par conséquent la surface de réalisation du circuit intégré sur silicium.

La tranchée d'isolation DTI1 est donc suffisamment profonde pour isoler la couche enterrée CE de la couche supérieure 5, et suffisamment fine pour être compatible avec la réalisation de circuits intégrés compacts.

Une autre tranchée d'isolation profonde DTI2 est réalisée de façon à isoler le circuit intégré et par conséquent le pixel qui lui est associé, à un autre circuit intégré qui lui serait adjacent dans le cas d'un capteur d'image CIM comprenant une matrice avec plusieurs pixels, tel que représenté sur la figure 1.

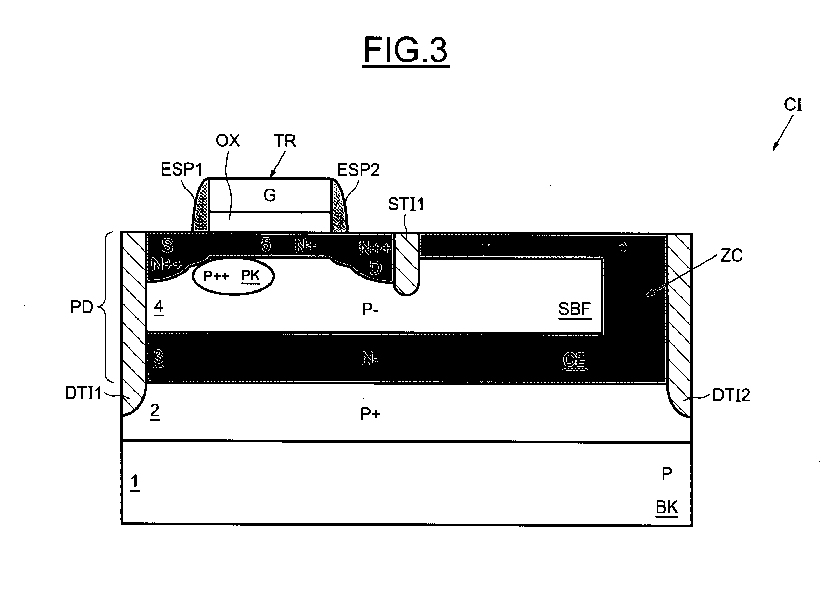

On a représenté sur la figure 3, un autre mode de réalisation du circuit intégré CI. Sur cette figure, le circuit intégré comprend une première tranchée d'isolation auxiliaire STI1, qui a pour but d'optimiser la surface du circuit intégré CI sur silicium, tel que décrit ci-après.

La tranchée STI1 est de préférence de type « Shallow Trench Isolation », c'est-à-dire une tranchée d'isolation peu profonde et remplie d'oxyde de silicium. La tranchée d'isolation STI1 traverse la couche supérieure 5, de façon à isoler le drain 1 du transistor de lecture TR de la couche supérieure 5 réalisant la photodiode PD. Cela permet d'avoir un circuit intégré sur silicium plus compact, tel que décrit ci-après.

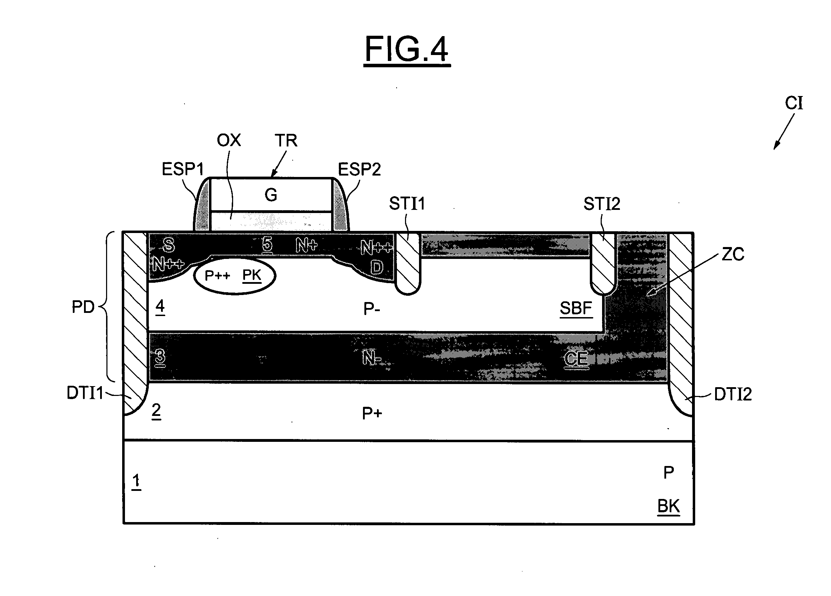

Dans ce cas, comme illustré sur la figure 4, le circuit intégré CI peut en outre comprendre une zone ZC pour une reprise de contact sur la couche enterrée CE. Le circuit CI comprend alors une deuxième tranchée d'isolation STI2, de type « Shallow Trench Isolation ». Cette isolation permet de séparer la couche enterrée CE de la couche supérieure 5. Ainsi, il est possible de polariser la couche enterrée CE, indépendamment du drain D.

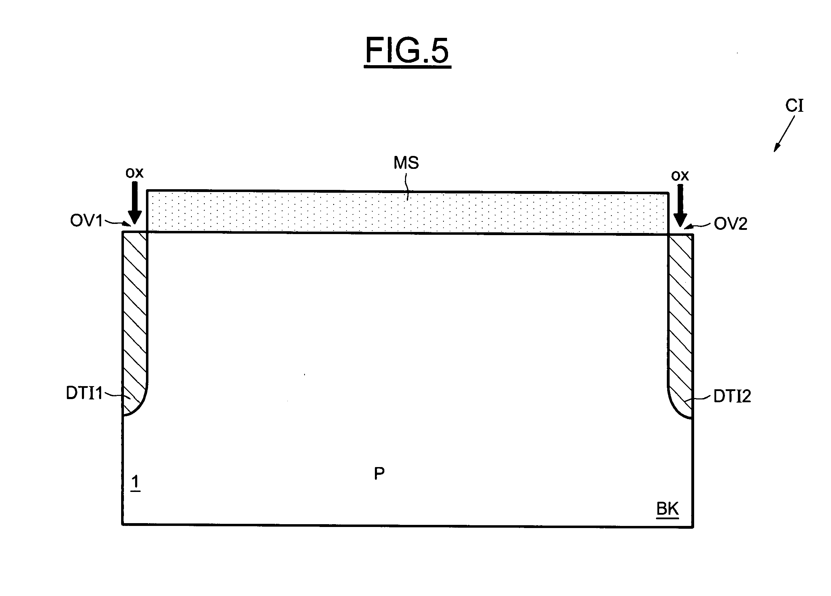

On se réfère à présent aux figures 5 à 12, illustrant un exemple d'un procédé de fabrication du circuit intégré représenté sur la figure 4.

Tel qu'illustré sur la figure 5, on fait croître la couche 1 par épitaxie selon une technique bien connue de l'homme du métier, de façon à réaliser le support BK du circuit intégré CI.

Puis, on dépose une couche de résine sur la couche 1. On définit alors par gravure de la résine deux ouvertures OV1 et OV2 localisées aux extrémités de la couche 1. On a par conséquent réalisé un masque de résine MS sur la couche 1 où seules les ouvertures OV1 et OV2 issues de la gravure de la résine, subsistent à chaque extrémité.

Puis, on procède à la formation de deux tranchées DTI1 et DTI2 au niveau des deux ouvertures OV1 et OV2. La réalisation des tranchées comporte notamment une gravure de la couche 1, selon une technique bien connue de l'homme du métier. Par exemple, en technologie 120 nm, les tranchées DTI1 et DTI2 peuvent avoir une profondeur comprise entre 1 et 1,5 µm.

Ces tranchées sont remplies d'un isolant OX, par exemple de l'oxyde de silicium. Puis, on procède à un recuit pendant 90 minutes, à une température de 1050 °C.

On retire alors le premier masque MS de résine.

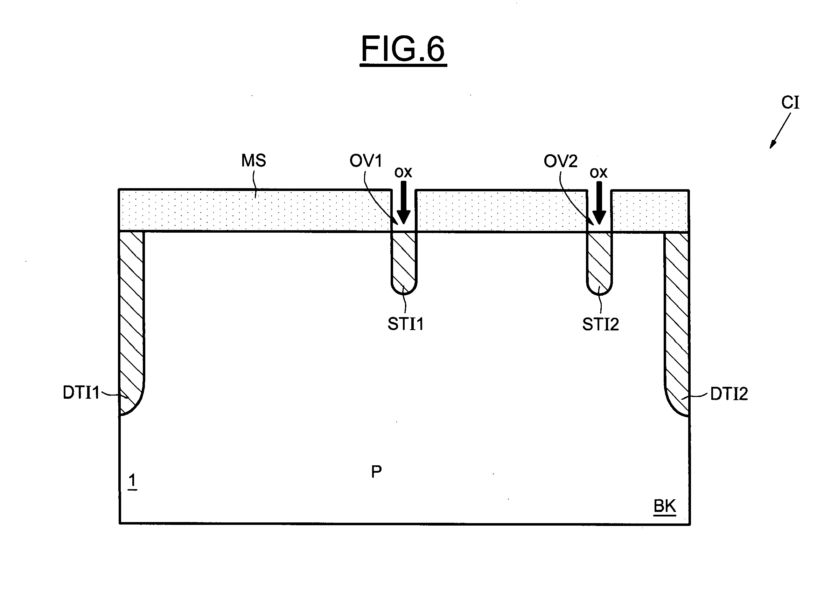

On réalise (figure 6) un nouveau masque de résine MS avec deux nouvelles ouvertures OV1 et OV2 pour former les deux tranchées d'isolation STI1 et STI2.

Le nouveau masque de résine et les tranchées d'isolation sont réalisés tel que décrit précédemment.

La profondeur des tranchées d'isolation auxiliaires STI1 et STI2 est beaucoup moins importante que celle des tranchées d'isolation DTI1 et DTI2. Par exemple, en technologie 120 nm, cette profondeur est de l'ordre de 0,3 µm. Après le remplissage d'oxyde, on procède à un recuit à une température de l'ordre de 1050°C pendant 90 minutes.

Les tranchées d'isolation DTI1, DTI2, STI1 et STI2, sont réalisées au début du procédé. En effet, les différents recuits nécessaires demandent des températures élevées sur une durée relativement importante. En les réalisant en milieu de procédé, il y aurait un risque de diffusion des dopants entre les différentes couches du circuit intégré CI.

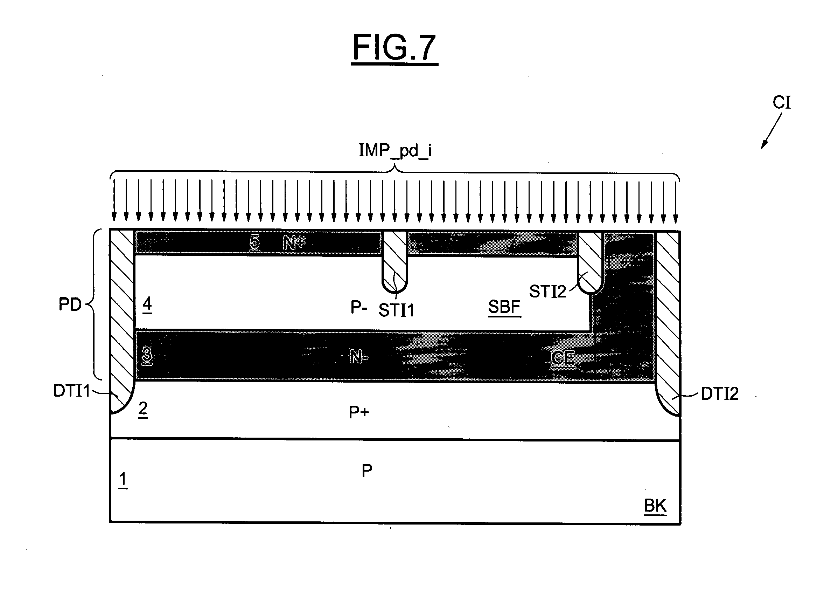

A l'issue de la formation des tranchées d'isolation, on réalise (figure 7) par implantations successives IMP_pd_i dans la couche 1, la couche semi-conductrice 2 dopée P+ ainsi que les différentes couches 3, 4 et 5 formant la photodiode PD.

La couche 3 de la photodiode PD, ici dopée N, définit la couche enterrée CE. La couche médiane 4, ici dopée P⁻ sert à réaliser le substrat flottant SBF de la photodiode PD. Ainsi elle est entourée de la couche enterrée CE et de la couche supérieure 5, ici dopée N⁺, réalisée au-dessus de la couche 4.

La couche 4 servant à réaliser le substrat flottant SBF, est par conséquent entièrement entourée de matériaux semi-conducteurs, d'un type de conductivité opposé.

Les différentes implantations peuvent être réalisées sans utiliser de masque autre que des masques de protection pour certaines parties du circuit intégré ainsi qu'un masque de façon que le substrat flottant SBF soit entouré d'une couche semi-conductrice d'un type de conductivité opposé. En effet, les implantations successives IMP_pd_i sont directement auto-alignées sur les différentes tranchées DT1, DT2, ST1 et ST2 qui ne nécessitent pas de masque de protection puisque remplies d'oxyde. On s'affranchit ainsi des incertitudes liées au masquage.

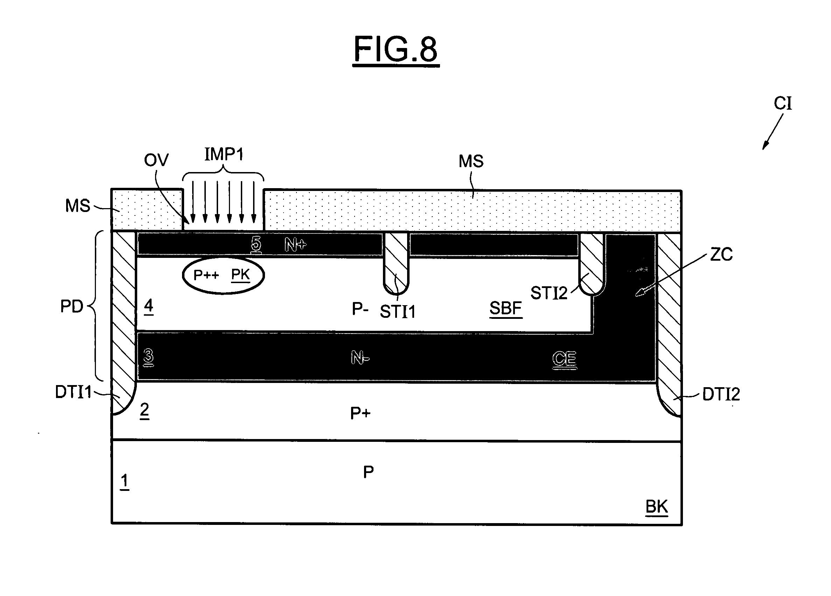

Ensuite, on réalise ici (figure 8) une zone de stockage PK surdopée P⁺ par une implantation IMP1 à travers une ouverture OV réalisée dans un masque MS. Il serait possible de ne pas réaliser cette zone de stockage PK et de stocker les charges photogénérées directement à l'intérieur du substrat flottant SBF.

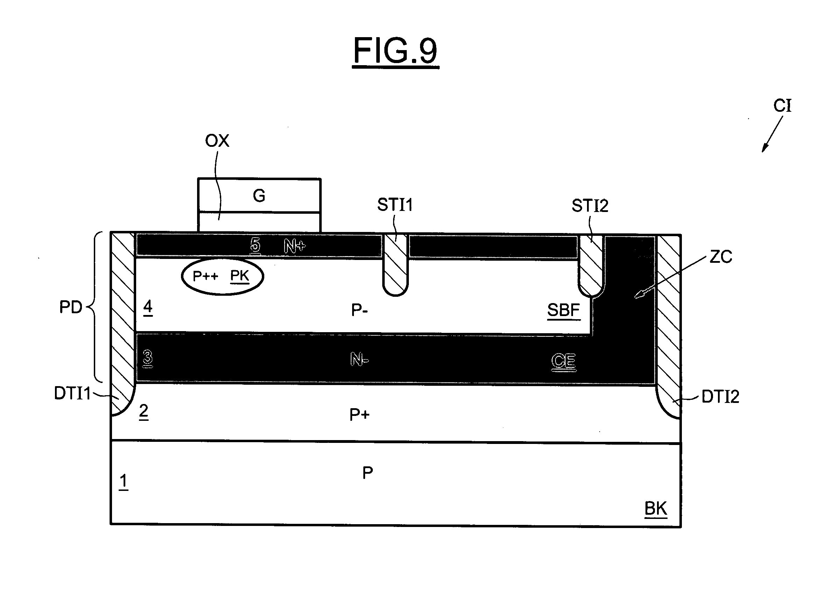

Puis, on réalise (figure 9) de manière classique la grille G du transistor de lecture TR séparée de la couche supérieure 5 par une couche d'oxyde OX.

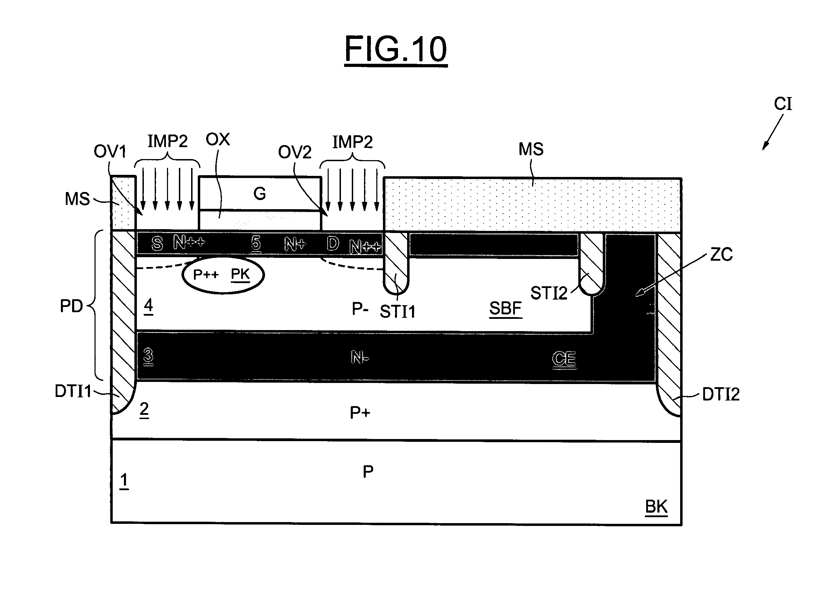

On réalise (figure 10) ensuite les zones de source et de drain de chaque côtés de la grille G, de type rectangulaire, par une autre implantation IMP2 à travers deux nouvelles ouvertures OV1 et OV2 réalisées dans un masque MS.

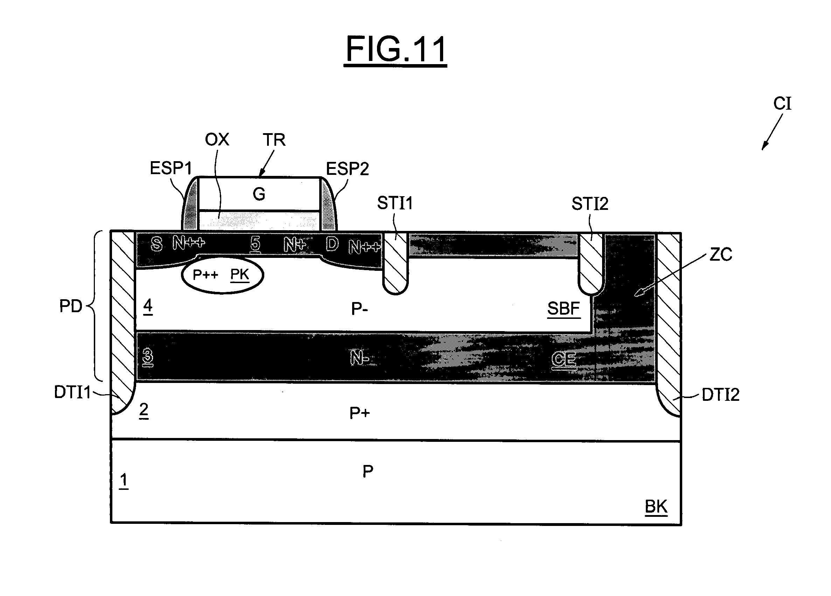

Puis, on forme de façon classique et connue en soi, deux espaceurs ESP1 et ESP2, de chaque côtés de la grille G du transistor de lecture TR (figure 11).

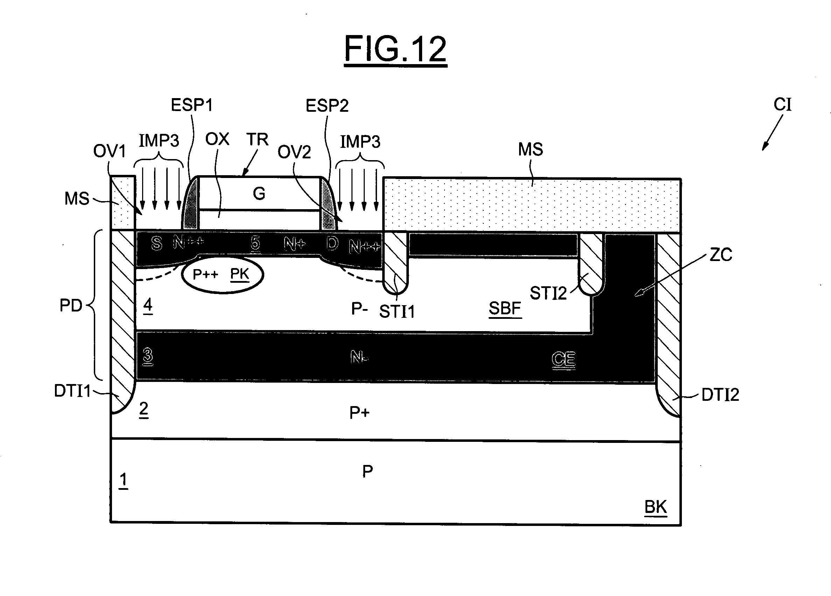

Il est possible de réaliser (figure 12) une nouvelle implantation de dopants IMP3 au niveau des zones de source et de drain S et D. L'implantation de dopants IMP3 se fait à travers deux nouvelles ouvertures OV1 et OV2, réalisées dans un masque MS, de chaque côté de la grille G.

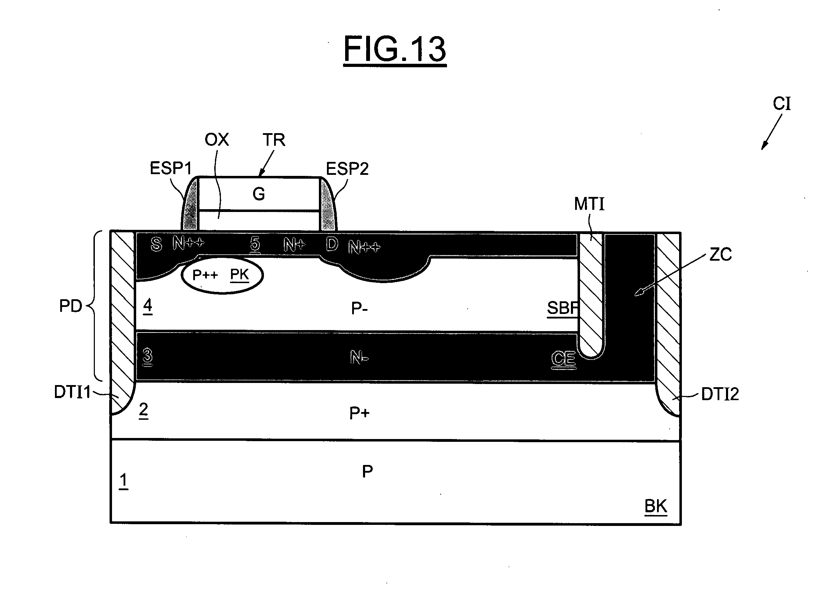

Sur la figure 13, on a représenté un autre mode de réalisation du circuit intégré, selon l'invention. Ce mode de réalisation ne comprend plus les deux tranchées d'isolation auxiliaires STI1 et STI2, mais conserve une zone de contact ZC sur la couche enterrée CE. De façon à isoler la zone de contact ZC de la couche supérieure 5, suffisamment pour éviter la diffusion des dopants pouvant avoir lieu au cours des différents recuits du procédé de fabrication, le circuit intégré comprend entre la zone de contact ZC et le substrat flottant SBF, une autre tranchée d'isolation MTI. Cette tranchée d'isolation est de préférence de type « Medium Trench Isolation », c'est-à-dire une tranchée d'isolation moyennement profonde. Cette tranchée d'isolation MTI s'étend jusqu'à la couche enterrée CE, de façon à complètement séparer le substrat flottant SBF de la zone de contact ZC.

Il est possible de réaliser sur silicium le circuit intégré selon l'invention, d'après différentes topologies. Deux configurations possibles sont présentées ci-dessous, à titre d'exemple, celles-ci étant en aucun cas limitatives.

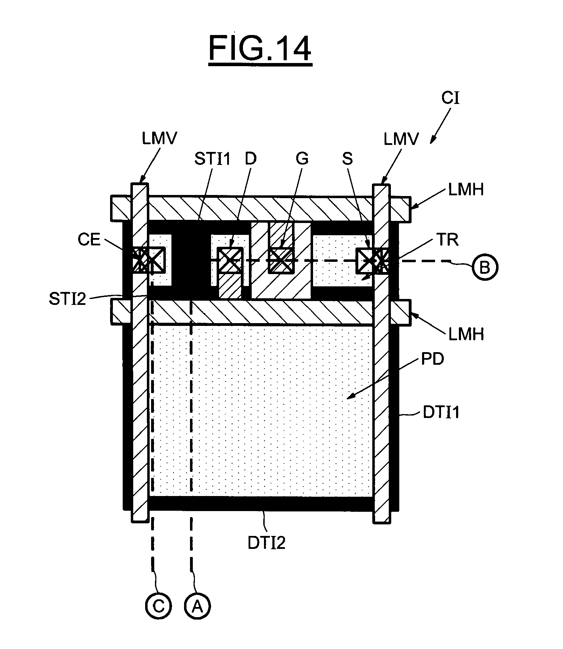

Par exemple, la figure 14 représente la photodiode PD entourée d'une couche d'isolant de type DTI qui correspond aux tranchées d'isolation profondes DTI2 pour isoler deux pixels appartenant à deux lignes différentes adjacentes, et DTI1 de façon à isoler en outre la zone de photodiode PD de la couche enterrée CE, comme on peut le voir en suivant la ligne en traits pointillés B.

Le transistor de lecture TR est réalisé de façon compacte sur une partie du circuit intégré CI. Il comprend une grille G à section rectangulaire. De part et d'autre, on retrouve le drain et la source, respectivement D et S.

La zone de drain D est séparée de la photodiode PD par une tranchée d'isolation STI1 de la photodiode PD, tel qu'on peut le voir selon la ligne en pointillés A. Par ailleurs, la couche enterrée est isolée de la photodiode PD par la deuxième tranchée auxiliaire STI2, de façon à réaliser une reprise de contact sur la couche enterrée CE comme on peut le voir en suivant la ligne en traits pointillés C.

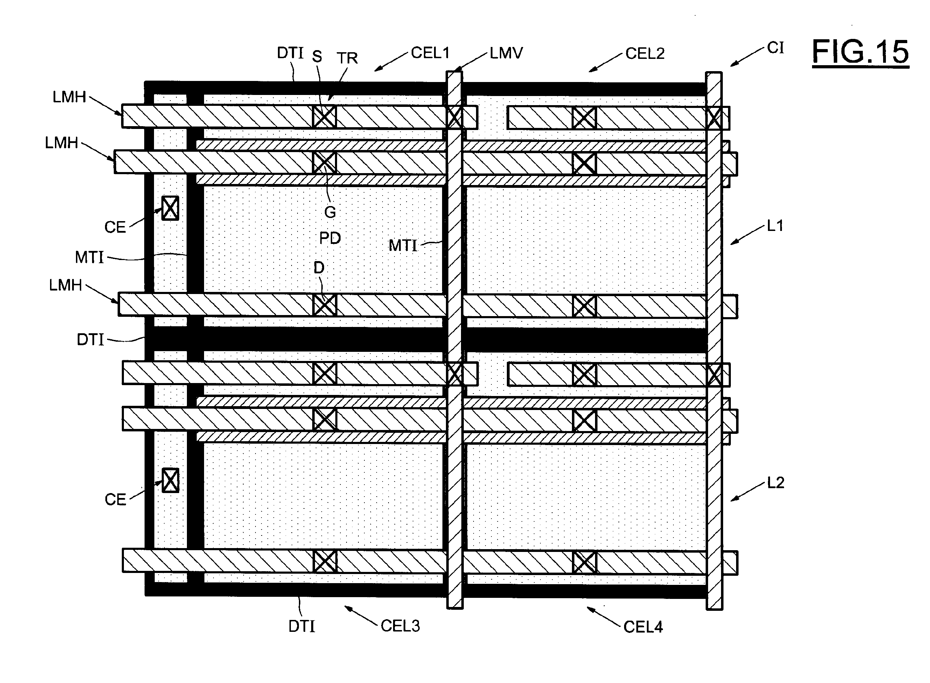

Sur la figure 15, on a réalisé un circuit intégré comprenant quatre cellules distinctes CL1, CL2, CL3 et CL4 (par exemple des pixels).

Ces cellules sont réparties sur deux lignes différentes L1 et L2, isolée entre-elles par des isolations de type DTI.

De façon à réaliser une seule reprise de contact sur la couche enterrée des pixels appartenant à une même ligne, on réalise une tranchée d'isolation de type MTI entre chaque pixel, de façon à isoler chacun des substrats flottants sans couper la couche enterrée. De cette façon, il est possible de réaliser une zone de contact de la couche enterrée CE à l'extrémité (ou aux deux extrémités) de chacune des lignes et non pour chaque pixel.

## Revendications

1. Circuit intégré comprenant au moins une photodiode (PD) de type à substrat flottant, associée à un transistor de lecture (TR), ladite photodiode comportant une couche enterrée (CE) située sous le substrat flottant (SBF) et une couche supérieure (5) située sur le substrat flottant et incorporant les zones de sources (S) et de drain (D), **caractérisé par le fait que** les zones de source et de drain sont réalisés de part et d'autre de la grille (G) du transistor de lecture (TR) et que le circuit comprend une tranchée d'isolation (DTI1), située à côté de ladite zone de source, s'étendant depuis la surface supérieure de la couche supérieure (5) et au-delà de la couche enterrée (CE), de façon à isoler la zone de source (S) de ladite couche enterrée(CE).

2. Circuit intégré selon la revendication précédente, comprenant en outre une zone de contact (ZC) semi-conductrice du même type de conductivité que la couche enterrée (CE) et électriquement isolée de la couche supérieure, s'étendant entre la surface supérieure de la couche supérieure (5) et la couche enterrée (CE).

3. Circuit intégré selon l'une quelconque des revendications précédentes, comprenant une première tranchée d'isolation auxiliaire (STI1) située entre la zone de drain (D) du transistor et la photodiode, et traversant ladite couche supérieure (5).

4. Circuit intégré selon les revendications 3 et 4, comprenant une zone de contact (ZC) semi-conductrice du même type de conductivité que la couche enterrée (CE) et électriquement isolée de la couche supérieure (5) et comprenant en outre une deuxième tranchée d'isolation auxiliaire (STI2) située entre la photodiode et ladite zone de contact (ZC) semi-conductrice, et traversant ladite couche supérieure (5).

5. Circuit intégré selon la revendication 3, comprenant une zone de contact (ZC) semi-conductrice du même type de conductivité que la couche enterrée (CE) et électriquement isolée de la couche supérieure (5) et comprenant en outre une tranchée d'isolation auxiliaire (MTI), située entre la photodiode et la zone de contact (ZC) semi-conductrice, s'étendant depuis la surface supérieure de la couche supérieure (5) et au-delà de la couche enterrée (CE).

6. Circuit intégré **caractérisé par le fait qu'**il comprend plusieurs ensembles de photodiodes associées à des transistors de lecture selon l'une quelconque des revendications 1 à 5.

7. Capteur d'image **caractérisé par le fait qu'**il comprend un circuit intégré selon l'une quelconque des revendications 1 à 6, chaque ensemble photodiode/transistor définissant un pixel du capteur.
